Europäisches Patentamt

European Patent Office

Office européen des brevets

(11) Veröffentlichungsnummer: **0 246 611**

**A2**

(12) **EUROPÄISCHE PATENTANMELDUNG**

(21) Anmeldenummer: **87107269.0**

(22) Anmeldetag: **19.05.87**

(51) Int. Cl.⁴: **G02B 27/10 , G02B 17/00**

(30) Priorität: **20.05.86 DE 3616960**

(43) Veröffentlichungstag der Anmeldung:
**25.11.87 Patentblatt 87/48**

(84) Benannte Vertragsstaaten:
**CH DE FR GB IT LI NL**

(71) Anmelder: **Karl Süss KG Präzisionsgeräte für Wissenschaft und Industrie - GmbH & Co.**
**Schleissheimer Strasse 90 Postfach 1809**
**D-8046 Garching bei München(DE)**

(72) Erfinder: **Kaiser, Paul**
**Hessstrasse 28**
**D-8000 München 40(DE)**

(74) Vertreter: **Vossius & Partner**
**Siebertstrasse 4 P.O. Box 86 07 67**
**D-8000 München 86(DE)**

(54) Optische Anordnung zum Erzeugen von zueinander gekreuzten linearen Bildelementen.

(57) Mit der beschriebenen optischen Anordnung wird aus einem linearen Objektelement ein Bild aus zwei sich unter einem bestimmten Winkel kreuzenden Geraden erzeugt. Damit ist es möglich, mit einer einzigen eingangsseitigen linearen Abtastbewegung ausgangsseitig eine kreuzweise Bewegung des Bildpunktes zu erreichen. Insbesondere können so mit einer einzigen Abtastbewegung flächige Gebilde in zwei Richtungen abgetastet werden.

Fig. 1

## Optische Anordnung zum Erzeugen von zueinander gekreuzten linearen Bildelementen

Zur Justierung von Geräten oder Bauelementen sowie insbesondere zur Justierung von Masken und Halbleiterscheiben (Wafer) bei der Herstellung von Halbleiterbauelementen (wie integrierten Schaltkreisen - IC) wird ein Lichtpunkt oder ein Lichtband kreuzweise über zueinander zu justierende Markierungspunkte geführt. Um etwa durch visuelle Beobachtung oder selbsttätig mit Hilfe von Detektoren und einer Regelschleife, die Ausrichtung zu optimieren, können auf dem Substrat und auf der Maske komplementäre Fadenkreuze vorgesehen werden, die zum Justieren zur Deckung gebracht werden müssen (vgl. die DE-AS 24 21 509 und DE-PS 27 08 674). Dies erfordert eine relativ große Lichtquelle, da der Strahlquerschnitt im Bereich von Maske und Substrat etwa den Abmessungen der Markierungen (Fadenkreuze) entsprechen muß, um die gesamte Markierung zu beleuchten. Diese Forderung erschwert den Einsatz von Laserlichtquellen, die den Vorteil der monochromen und kohärenten Strahlung haben.

Im Rahmen der Erfindung wurde erkannt, daß Laserlichtquellen und allgemein Lichtquellen mit relativ kleinem Strahlquerschnitt eingesetzt werden können, wenn man diesen Strahl über die Markierungen bzw. die Fadenkreuze "führt", also die Markierung z.B. kreuzweise abtastet (scanning).

Um nun diese gekreuzte Abtastbewegung zu erzeugen, müßte die Lichtquelle entsprechend den beiden gekreuzten Linien in einer Ebene in zwei verschiedenen Richtungen bewegt werden, d.h. es sind zwei Antriebe für diese Bewegung der Lichtquelle bzw. ein geeignetes Strahlablenksystem erforderlich; in manchen Anwendungsfällen müssen darüber hinaus diese beiden Bewegungen miteinander synchronisiert werden. Dies erfordert einen erheblichen mechanischen und optischen Aufwand, zumal die Anforderungen an die Genauigkeit derartiger Justiereinrichtungen definitionsgemäß sehr hoch sind.

Demgegenüber liegt der Erfindung die Aufgabe zugrunde, eine optische Anordnung zum Erzeugen eines Bildes in Form von zueinander gekreuzten linearen Bildelementen zu schaffen, die eine Vereinfachung der Bewegung des einfallenden Strahls ermöglicht.

Diese Aufgabe wird mit den Merkmalen der Patentansprüche gelöst.

Bei der Lösung geht die Erfindung von dem Grundgedanken aus, durch geeignete Ausbildung der beanspruchten optischen Anordnung die gekreuzten linearen Bildelemente aus zugeordneten linearen Objektelementen abzubilden, die jedoch nicht gekreuzt, sondern zueinander parallel und vorzugsweise gleichgerichtet aneinander anschließend oder zumindest teilweise überlappend angeordnet sind. Bei der bevorzugten zweiten Alternative werden also die beiden Objektelemente, die auf einer gemeinsamen Geraden liegen, in Form von zwei zueinander gekreuzten Bildelementen abgebildet. Bei der ersten Alternative sind die beiden Objektelemente zueinander parallel, d.h. auch in diesem Fall genügt eine einsinnige Bewegung zweier Lichtpunkte in bestimmtem Abstand, um die gekreuzten Bildelemente zu erzeugen. Bei der zuerst erörterten, bevorzugten zweiten Alternative ist es sogar im Rahmen der Erfindung möglich, anstelle zweier auf einer gemeinsamen Geraden angeordneten Objektelementen lediglich ein einziges lineares Objektelement vorzusehen, das zunächst über einen Strahlteiler, z.B. in Form eines halbdurchlässigen Spiegels oder einer entsprechend wirkenden Prismenanordnung, in zwei zueinander parallele Zwischenbildelemente aufgeteilt wird. Diese beiden Zwischenbildelemente werden dann in ähnlicher Weise wie bei den anderen Alternativen zunächst zueinander gedreht und dann ausgangsseitig überlagert, so daß man in einer gemeinsamen Bildebene sich kreuzende geradlinige Bildelemente erhält.

Für den Aufbau der erfindungsgemäßen optischen Anordnung können beispielsweise übliche Strahlteiler (z.B. halbdurchlässige Spiegel oder zwei aufeinanderliegende Dachkantenprismen mit halbdurchlässiger Grenzfläche) oder rautenförmige Prismen als Parallelversetzer, Dachkantenprismen oder Spiegel zum Drehen der Strahlengänge sowie gedrehte Strahlteiler als Strahlüberlagerungseinrichtung eingesetzt werden.

Bei der in der Zeichnung dargestellten Ausführungsform werden ausschließlich Prismen für den Aufbau der erfindungsgemäßen optischen Anordnung verwendet, wobei dort 90°-Dachkantenprismen einen Winkel von 90° zwischen den beiden Bildelementen bewirken.

Vorzugsweise ist die erfindungsgemäße optische Anordnung so gewählt, daß die optischen Weglängen für die Abbildung beider Objektelemente bis zur Bildebene gleich sind, so daß für beide optischen Weglängen die eingangsseitige Fokusierung in die Bildebene erhalten bleibt.

Mit Hilfe der erfindungsgemäßen optischen Anordnung kann mit Hilfe eines sich eingangsseitig geradlinig bewegenden Lichtflecks in der Bildebene ausgangsseitig eine Abtastung in X-und in Y-Richtung entweder gleichzeitig oder nacheinander erfolgen, je nachdem, wie der eingangsseitige Strahlteiler ausgebildet ist. Dadurch genügt eingangsseitig eine einzige geradlinige Abtastbewegung, um ausgangsseitig eine gekreuzte Strahlbewegung zu erzeugen. beispielsweise zur einzigen Abtasteinrichtung senkrechten Richtung kann daher verzichtet werden, so daß auch eine eventuelle Synchronizichtet werden, so daß auch eine eventuelle Synchronisation der beiden Abtasteinrichtungen, wie sie beim Stand der Technik erforderlich ist, erfindungsgemäß unnötig wird, da eine derartige "Synchronisierung" sich selbsttätig ergibt.

Da ferner die erfindungsgemäße optische Anordnung keinerlei bewegliche Teile enthält, genügt eine einmalige genaue Justierung der verschiedenen optischen Bauelemente, um in Verbindung mit einer einzigen eingangsseitigen Abtasteinrichtung zueinander gekreuzte Linien mit höchster Reproduzierbarkeit ausgangsseitig abzutasten.

Unter dem Begriff "Lichtfleck" des eingangsseitigen Lichtstrahls können verschiedene Formen und Querschnitte des einfallenden Lichtstrahls subsummiert werden, beispielsweise ein Lichtpunkt oder ein quer zur Abtastrichtung sich erstreckendes Lichtband, so daß in diesen beiden geschilderten Fällen ausgangsseitig ein Lichtkreuz bzw. eine quadratische oder rechteckige Fläche fortschreitend in beiden Richtungen abgetastet wird.

Die Erfindung wird nachstehend mit Bezug auf die anliegende Zeichnung näher erläutert. Es zeigen:

Figur 1 eine perspektivische Ansicht einer erfindungsgemäßen optischen Anordnung, die aus mehreren verschiedenen Prismen zusammengesetzt ist,

Figuren 2a - 2c eine Aufsicht, eine Seitenansicht bzw. eine Vorderansicht der optischen Anordnung gemäß Figur 1.

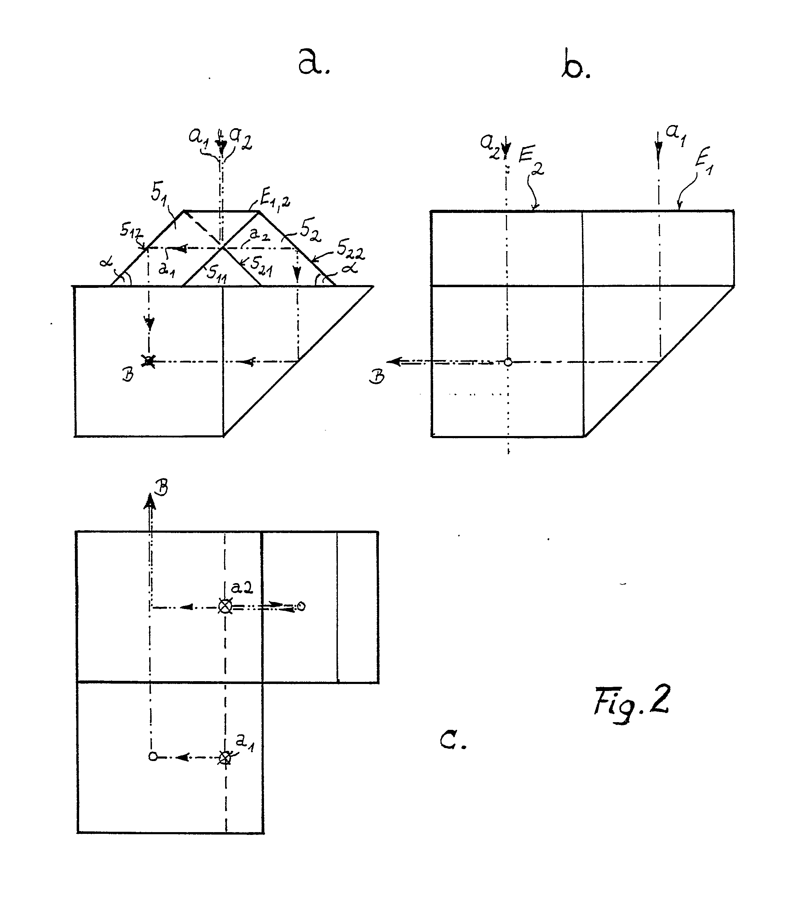

Die in der Zeichnung dargestellte Ausführungsform einer erfindungsgemäßen optischen Anordnung, die aus mehreren geeignet angeordneten Prismen besteht, wird nachstehend als X-Y-Prisma bezeichnet, das bei dieser Ausführungsform aus einem geradlinigen Objekt A1, A2 zwei sich senkrecht schneidende Bildelemente B1 und B2 erzeugt. Ausgehend von dem Objekt A1, A2 trifft der Strahlengang für die verschiedenen Objektelemente A1 und A2 zunächst auf einen Strahlteiler mit Parallelversetzer $5_1$ und $5_2$, der bewirkt, daß die Strahlengänge a1 und a2 für die beiden Objektelemente A1 bzw. A2 in Axialrichtung des Objekts gesehen (vgl. Figur 2a) voneinander getrennt und dabei parallel zueinander versetzt werden. Zu diesem Zweck besteht der Strahlteiler mit Parallelversetzer aus zwei im Querschnitt rautenförmigen Prismen $5_1$ und $5_2$, deren Strahleintrittsflächen $E_1$ und $E_2$ in einer gemeinsamen Ebene senkrecht zu den Strahlengängen $a_1$ und $a_2$ liegen. Nach dem Durchtritt durch die Eintrittsflächen $E_1$ und $E_2$ werden die Strahlen $a_1$ bzw.

$a_2$ an der jeweils gegenüberliegenden Prismenfläche $5_{11}$ bzw. $5_{2'}$ der beiden Prismen $5_1$ bzw. $5_2$ totalreflektiert (in der Darstellung gemäß Figur 2a nach links bzw. rechts) und werden dann an den jeweils gegenüberliegenden Prismenflächen $5_{12}$ bzw. $5_{22}$ ebenfalls total reflektiert und sind danach gemäß Figur 2a zueinander parallel. Damit diese Strahlteilung und Parallelversetzung geometrisch richtig erfolgt, haben die beiden Rautenprismen $5_1$ und $5_2$ jeweils einen Rautenwinkel $\alpha = 45°$.

Auf diese Parallelversetzer $5_1$ und $5_2$ könnte verzichtet werden, wenn man z.B. anstelle der beiden untereinander liegenden Objektelemente A1 und A2 zwei nebeneinander liegende Objektelemente verwendet, die gemeinsam, d.h. parallel zueinander bewegt werden.

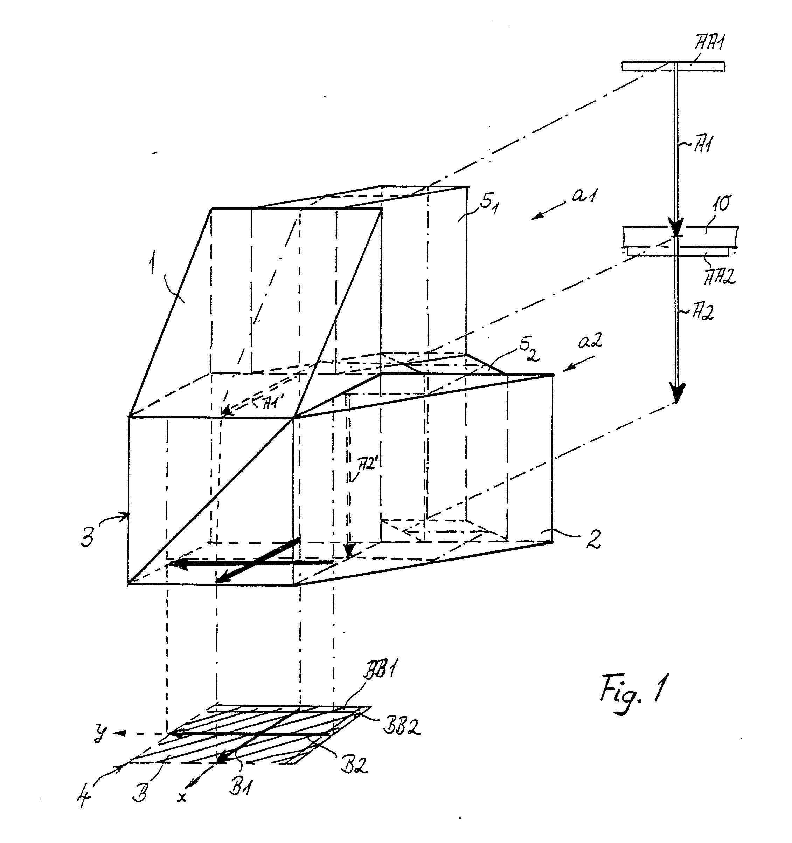

Nach dem Parallelversatz der beiden Objektelemente A1 und A2 in den Prismen $5_1$ und $5_2$ treten die beiden Strahlengänge a1 bzw. a2 in Dachkantenprismen 1 bzw. 2 ein, die um 90° gegeneinander verdreht sind, um die Strahlengänge a1 und a2 dementsprechend um 90° gegeneinander zu verdrehen (Zwischenbild A1' bzw. A2'). Um nun zu erreichen, daß die beiden Strahlengänge wiederum in einer gemeinsamen Bildebene abgebildet werden, befindet sich ausgangsseitig zu den beiden Dachkantenprismen 1 und 2 eine gemeinsame Strahlüberlagerungseinrichtung 3 in Form eines um 90° gedrehten Strahlteilers, dessen halbdurchlässige Grenzfläche 6 für den Strahlengang a1 durchlässig und für den Strahlengang a2 reflektierend ist, so daß die Strahlen a1 und a2 in Figur 1 nach unten und in Figur 2a senkrecht zur Papierebene nach unten austreten.

Für die verschiedenen Objektpunkte auf dem linearen Objektelement A1 ergibt sich dann für verschiedene zueinander parallele Strahlengänge a1 ausgangsseitig das Bildelement B1, und entsprechend erhält man aus den verschiedenen Objektpunkten des linearen Objektelements A2 über die verschiedenen zueinander parallelen Strahlengänge a2 ausgangsseitig das lineare Bildelement B2, das sich mit dem linearen Bildelement B1 unter einem Winkel von 90° kreuzt.

Durch geeignete Modifizierung der eingangsseitigen Objektelemente bildet das erfindungsgemäße X-Y-Prisma eine flächige Struktur ab: wird beispielsweise ein Lichtband AA1 über die Strecke A1 und anschließend als Lichtband AA2 über die Strecke A2 bewegt, so erhält man ausgangsseitig zunächst eine Abbildung BB1 des Lichtbandes AA1, das sich in Pfeilrichtung auf der Strecke B1 bewegt, und anschließend erhält man für das eingangsseitige Lichtband AA2 auf der Strecke A2 ausgangsseitig die Abbildung BB2. die sich in Pfeilrichtung auf der Strecke B2 in Figur 1 nach links bewegt. Dadurch wird nacheinander der - schraffierte Bereich B in X-bzw. in Y-Richtung abgetastet.

Um ein Ausfransen oder Übersprechen zwischen den beiden Strahlengängen a1 und a2 zu vermeiden, kann am Übergang zwischen den beiden Objektelementen A1 und A2 eine geeignete Blende 10 vorgesehen sein, so daß die beiden Objektelemente A1 und A2 nicht kontinuierlich ineinander übergehen sondern unterbrochen sind.

Wie eingangs dargelegt, ist es auch möglich, ein einziges objektseitiges Element in einem üblichen Strahlteiler, wie halbdurchlässigen Spiegeln oder mit halbdurchlässiger Grenzfläche zwischen zwei Prismen, aufzuteilen, geeignet parallel zu versetzen und schließlich so zu überlagern, daß man ebenfalls wie bei der in der Zeichnung dargestellten Figur eine sich kreuzende Abbildung eines einzigen Objektelements erhält. In diesem Fall könnte ggf. auch auf die Verwendung der Parallelversetzer $5_1$ und $5_2$ verzichtet werden.

Im Rahmen der Erfindung können anstelle der in der Zeichnung dargestellten Prismen auch Spiegel bzw. halbdurchlässige Spiegel eingesetzt werden.

Soll der Winkel zwischen den beiden Bildelementen B1 und B2 nicht 90° sondern einen anderen Wert annehmen, so müssen lediglich die Prismenwinkel bzw. die Winkel von den entsprechend eingesetzten Spiegeln in entsprechend geeigneter Weise verändert werden.

## Ansprüche

1. Optische Anordnung zum Erzeugen eines Bildes in Form von zueinander gekreuzten linearen Bildelementen (B1, B2), **dadurch gekennzeichnet,**

a) daß das Objekt aus linearen Objektelementen (A1, A2) besteht, die im wesentlichen zueinander parallel angeordnet sind,

b) daß der Strahlengang für das eine Objektelement (A2) in einer ersten Strahlablenkeinrichtung (2) gedreht wird und

c) daß in einer im Strahlengang des ersten und des zweiten Objektelements (A1, A2) nach der ersten Strahlablenkeinrichtung (2) liegenden Strahlüberlagerungseinrichtung (3) die beiden Strahlengänge auf eine gemeinsame Bildebene (4) gerichtet werden.

2. Optische Anordnung in Form eines Planflächensystems zur Abbildung zweier untereinander liegender und/oder parallel versetzter Bereiche eines abzubildenden, planen Objektes (AA1, AA2) in eine Bildfläche (B), wobei die Bilder (BB2, BB1) des einen (AA2) und des anderen Objektbereiches (AA1) in die gleiche Bildfläche (B) zusammenfallen und zueinander vorzugsweise um 90° gedreht sind, und wobei das Planflächensystem besteht

a) aus einer ersten und einer zweiten Strahlablenkeinrichtung (1 bzw. 2) zum Drehen der beiden Objektbereiche zueinander und

b) aus einer bildseitigen Strahlüberlagerungseinrichtung (3), für die beiden zueinander gedrehten Strahlengänge.

3. Optische Anordnung nach Anpsruch 1 oder 2, dadurch gekennzeichnet,

a) daß die beiden Objektelemente (A1, A2) gleichgerichtet sich eindimensional erstreckend angeordnet sind und

b) daß eingangsseitig ein Strahlteiler ($5_1$, $5_2$) und zumindest in einem der beiden geteilten Strahlengänge ein Parallelversetzer vorgesehen ist.

4. Optische Anordnung nach Anspruch 2 oder 3, dadurch gekennzeichnet, daß der Strahlteiler mit Parallelversetzer aus zwei komplementären, räumlich in Ausdehnungsrichtung des Objekts getrennt angeordneten, rautenförmigen Prismen ($5_1$, $5_2$) besteht, die jeweils den Objektbereichen (A1 bzw. A2) zugeordnet sind.

5. Optische Anordnung nach Anspruch 3 oder 4, dadurch gekennzeichnet, daß an die rautenförmigen Prismen ($5_1$, $5_2$) anschließend jeweils ein im Querschnitt dreieckiges Prisma (1 bzw. 2) als Strahlablenkeinrichtung vorgesehen ist.

6. Optische Anordnung nach Anspruch 4 oder 5, dadurch gekennzeichnet, daß als Strahlüberlagerungseinrichtung ein um 90° gedrehter Strahlteiler (3) verwendet wird.

7. Planflächensystem zur maßstabsgetreuen Abbildung zweier untereinander liegender Bereiche eines abzubildenden, planen Objektes (AA1, AA2) in eine zur Objektfläche senkrechte Bildfläche (B), wobei die Bilder (BB1, BB2) des oberen (AA1) und des unteren Objektbereiches (AA2) in die gleiche Bildfläche (B) zusammenfallen und zueinander um 90° verdreht sind, und wobei das Planflächensystem besteht

a) aus zwei objektseitigen, untereinander liegenden und parallel zueinander ausgerichteten Parallelversetzern ($5_1$, $5_2$) mit parallelogrammförmigem Querschnitt, deren Berührungsfläche ein gleichschenkliges Dreieck mit einer dem Objekt (AA1, AA2) zugewandten Basis bildet,

b) aus einem oberen (1) und einem unteren (2) rechtwinkligen Dachkantprisma als Strahlablenkeinrichtungen, deren koplanare Kathetenflächen an dem jeweils zugeordneten Parallelversetzer ($5_1$, $5_2$) anliegen und deren zweite Kathetenflächen in einer Kante senkrecht aneinanderstoßen.

c) aus einem bildseitigen Würfelprisma (3) als Strahlüberlagerungseinrichtung, welches in dem durch die beiden senkrecht aneinanderstoßenden Kathetenflächen der beiden rechtwinkligen Dachkantprismen (1, 2) definierten Raum liegt und mit einer halbdurchlässigen, durch die Kante dieser beiden Kathetenflächen verlaufenden Diagonalfläche versehen ist.

Fig. 1

a.

b.

c.

Fig. 2